Europäisches Patentamt

European Patent Office

Office européen des brevets

(11) Numéro de publication: **0 098 768**
**B1**

(12) **FASCICULE DE BREVET EUROPEEN**

(45) Date de publication du fascicule du brevet:
29.01.86

(51) Int. Cl.⁴: **G 01 R 33/04**

(21) Numéro de dépôt: 83401287.4

(22) Date de dépôt: 21.06.83

(54) **Sonde pour magnétomètre.**

(30) Priorité: 02.07.82 FR 8211658

(43) Date de publication de la demande:
18.01.84 Bulletin 84/3

(45) Mention de la délivrance du brevet:
29.01.86 Bulletin 86/5

(84) Etats contractants désignés:
IT SE

(56) Documents cités:
FR - A - 2 134 347
US - A - 2 916 696
US - A - 2 981 885
US - A - 3 434 047

(73) Titulaire: THOMSON-CSF, 173, Boulevard Haussmann,
F-75379 Paris Cedex 08 (FR)

(72) Inventeur: Guillemin, Germain, THOMSON-SCF
SCPI 173, bld Haussmann, F-75379 Paris Cedex 08 (FR)

(74) Mandataire: Desperrier, Jean-Louis et al,
THOMSON-CSF SCPI 173, Bld Haussmann,
F-75379 Paris Cedex 08 (FR)

## Description

L'invention a pour objet une sonde d'un appareil de mesure de champ magnétique ou magnétomètre, et plus particulièrement pour les magnétomètres dans lesquels un courant alternatif crée dans un circuit magnétique un flux atteignant des valeurs de saturation, auquel se superpose le flux résultant du champ à mesurer, la tension recueillie dans un enroulement disposé autour du circuit permettant la mesure de ce champ.

Les magnétomètres suivant l'art antérieur comportent des noyaux magnétiques saturables pour lesquels il n'y a pratiquement pas de couplage entre l'enroulement d'excitation et l'enroulement de mesure. La valeur du champ à mesurer est obtenue par la dissymétrie des signaux recueillis pendant deux alternances successives. Il est connu de mesurer directement cette dissymétrie ou le taux d'harmonique 2.

Il est connu d'après le brevet US N° 2981885, au nom de Schonstedt, d'obtenir le découplage entre les enroulements d'excitation et de mesure en réalisant le noyau magnétique par enroulement de deux rubans en matériau à grande perméabilité magnétique sur un cylindre creux non magnétique. Ces rubans sont enroulés en sens inverse et entrelacés et forment un circuit magnétique fermé. Le circuit électrique d'excitation est enroulé sur ce noyau de manière toroïdale. La dimension de la section du ruban est de l'ordre de quelques millimètres en largeur et de quelques centièmes de millimètre en épaisseur.

L'inconvénient d'un tel dispositif est sa difficulté de mise en œuvre car le ruban n'est pas souple et se prête mal au bobinage. Egalement au niveau de la jointure des deux extrémités, la mise en œuvre est difficile et nécessite une soudure. Cette technologie impose une longueur de noyau relativement grande qui ne convient pas pour la réalisation de capteurs de petites dimensions nécessaire à la mesure ponctuelle de champs magnétiques. Enfin, le volume de matériau magnétique utilisé et les contraintes mécaniques induites limitent la sensibilité.

Pour remédier à ces inconvénients, l'invention propose de réunir l'enroulement magnétique et l'enroulement d'excitation en les fabriquant à l'aide d'un fil unique constitué d'une partie centrale en matériau conducteur et d'une partie périphérique en matériau ferromagnétique.

D'autres caractéristiques et avantages ressortiront de la description qui va suivre illustrée par les figures qui représentent:

la fig. 1 le schéma de principe d'un magnétomètre à noyau saturable;

la fig. 2 le noyau magnétique bobiné, suivant l'art antérieur;

les fig. 3, 4 et 5 une variante de réalisation de l'invention.

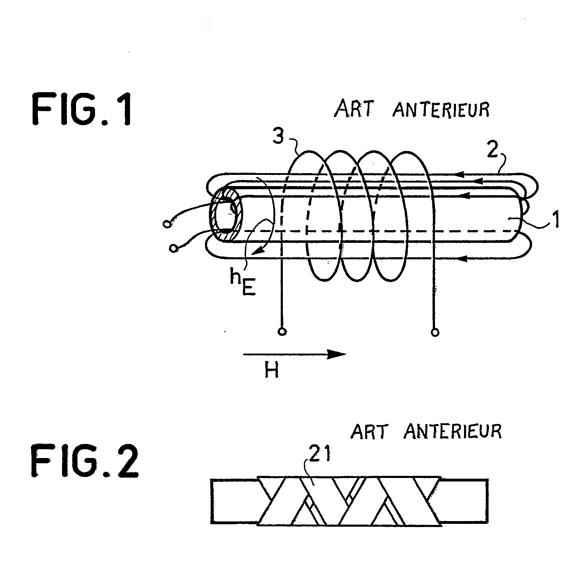

La fig. 1 montre le schéma général d'une sonde pour un magnétomètre à noyau saturable appelé flux-gate dans la littérature anglo-américaine. Le principe de mesure d'un champ magnétique H consiste généralement à détecter les harmoniques pairs, en particulier l'harmonique 2, qui prend naissance à la saturation d'un noyau magnétique sous l'effet du champ à mesurer qui se superpose au champ d'excitation alternatif.

Afin de minimiser la puissance d'excitation, par supression du champ démagnétisant, le noyau est de forme cylindrique et l'enroulement d'excitation est bobiné de manière toroïdale le long du noyau produisant un champ d'excitation $h_E$ dont les lignes de force entourent le noyau comme représenté à la fig. 1. Le noyau forme un tube 1 constitué en matériau à haute perméabilité, le bobinage d'excitation 2 produisant un champ $h_E$ alternatif. Aux bornes de l'enroulement de détection 3, on obtient le signal de mesure.

Dans certaines réalisations, le champ d'excitation $h_E$ est produit en faisant passer le courant directement dans le noyau 1.

La fig. 2 montre un noyau magnétique réalisé avec des rubans entrelacés 21 suivant l'art antérieur. La dimension de la section du ruban est de l'ordre de quelques millimètres en largeur et de quelques centièmes de millimètre en épaisseur.

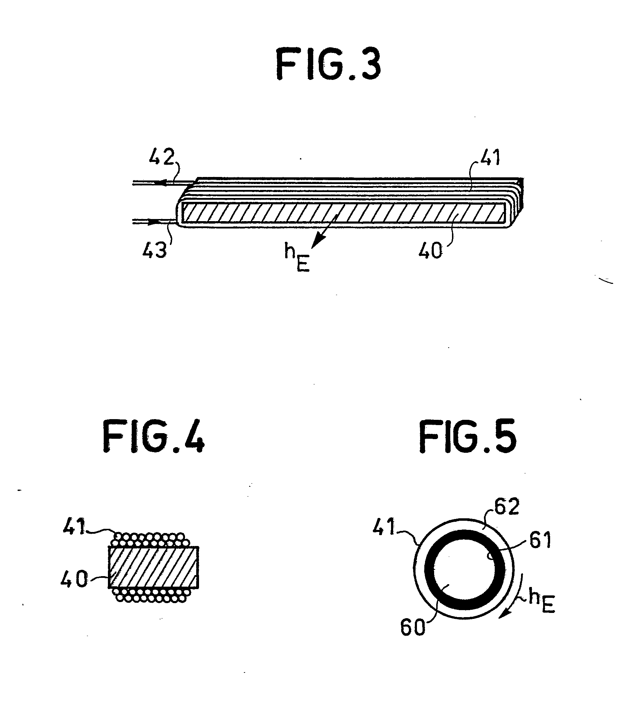

Les fig. 3, 4 et 5 représentent une variante de réalisation du noyau magnétique suivant l'invention. Sur un support 30 en quartz par exemple, de forme en parallélépipède rectangle allongé, est bobiné à spires jointives, avec un fil isolé, un fil de section ronde 41 en plusieurs couches dont les deux extrémités 42 et 43 sont laissées libres d'un côté du support. Le fil 41 est composé d'une partie centrale 60 en matériau conducteur tel que du cuivre et d'une partie périphérique 61 en matériau magnétique tel que du Mumétal ou un amorphe magnétique équivalent, ce matériau étant recouvert d'une couche d'isolant 62. Le courant d'excitation est envoyé dans le fil par les deux extrémités 42 et 43 produisant le champ d'excitation $h_E$.

La sonde ainsi obtenue selon cette forme de réalisation est de petites dimensions permettant la mesure ponctuelle d'un champ magnétique.

## Revendications

1. Sonde pour magnétomètre à noyau magnétique saturable comportant un enroulement d'excitation (2) destiné à être parcouru par un courant alternatif, un enroulement de mesure (3) destiné à fournir un courant alternatif dont la dissymétrie permet de mesurer le champ magnétique dans lequel est plongée la sonde, et un noyau magnétique formé par un enroulement (21) magnétique sur un support non magnétique, caractérisé en ce que l'enroulement magnétique et l'enroulement d'excitation sont formés par un fil unique (41) lui-même constitué d'une partie centrale (60) en matériau conducteur et d'une partie périphérique (61) en matériau ferromagnétique recouverte d'une couche isolante (62); les deux extrémités (42, 43) de ce fil étant destinées à être reliées à une source de courant alternatif.

2. Sonde selon la revendication 1, caractérisée en ce que le support non magnétique (40) est en forme de parallélépipède rectangle allongé dans le sens de sa plus grande longueur et que l'enroulement magnétique et d'excitation (41) est enroulé sur ce support dans le sens de sa plus grande largeur.

Form eines rechtwinkligen Quaders aufweist, der in der Richtung seiner grössten Länge gestreckt ist, und dass die magnetische Erregerwicklung (41) auf diesen Träger in Richtung seiner grössten Länge aufgewickelt ist.

**Patentansprüche**

1. Sonde für ein Magnetometer, mit sättigbarem Magnetkern, versehen mit einer Erregerwicklung (2), welche dazu bestimmt ist, von einem Wechselstrom durchflossen zu werden, einer Messwicklung (3), die dazu bestimmt ist, einen Wechselstrom zu liefern, dessen Unsymmetrie es gestattet, das Magnetfeld zu messen, in welches die Sonde eingetaucht ist, und mit einem Magnetkern, der durch eine magnetische Wicklung (21) auf einem unmagnetischen Träger gebildet ist, dadurch gekennzeichnet, dass die magnetische Wicklung und die Erregerwicklung durch einen einzigen Draht (41) gebildet sind, der seinerseits aus einem zentralen Teil (60) aus leitfähigem Material und einem Umfangsteil (61) aus ferromagnetischem Material und bedeckt mit einer Isolierschicht (62) gebildet ist, wobei die zwei Enden (42, 43) dieses Drahtes dazu bestimmt sind, mit einer Wechselstromquelle verbunden zu werden.

2. Sonde nach Anspruch 1, dadurch gekennzeichnet, dass der unmagnetische Träger (40) die

**Claims**

1. Magnetometer probe with saturable magnetic core comprising an excitation winding (2) intended to be traversed by an alternating current, a measurement winding (3) intended to furnish an alternating current whose asymmetry permits measurement of the magnetic field in which the probe is immersed, and a magnetic core formed by a magnetic winding (21) on a non-magnetic support, characterized in that the magnetic winding and the energization winding are formed by a single wire (41) constituted in turn by a central portion (60) of conductive material and a peripheral portion (61) of ferromagnetic material covered by an insulating layer (62), the two ends (42, 43) of said wire being intended to be connected to an alternating current source.

2. Probe according to Claim 1, characterized in that the non-magnetic support (40) is in the form of a rectangular parallelepiped extended in the direction of its greatest length, and that the magnetic energization winding (41) is coiled on said support in the direction of its greatest length.

# FIG.1

ART ANTERIEUR

$h_E$

H

# FIG.2

ART ANTERIEUR

21

# FIG.3

# FIG.4

# FIG.5